# EUROPEAN PATENT APPLICATION

(11) **EP 4 814 962 A1**
(43) Date of publication of application: **30.09.2026**
(21) Application number: 26165844.7
(22) Date of filing: 18.03.2026
(51) Int. Cl.: G11C 8/16, G11C 7/06

(54) **MULTI-PORT STATIC RANDOM ACCESS MEMORY**

(30) Priority: 24.03.2025 US 202519088831
(71) Applicant: Avago Technologies International Sales Pte. Limited, Singapore 768923 (SG)
(72) Inventor: Eklund, Eric William, Lakeville, 55044 (US); Hebig, Travis, Lakeville, 55044 (US); Everson, Luke Robert, Mendota Heights, 55118 (US)
(74) Representative: Dilg, Haeusler, Schindelmann Patentanwaltsgesellschaft mbH

(57) **Abstract**

An example memory circuit can include: a memory cell coupled to a first word line, a second word line, a first bit line, and a second bit line, the first word line selectively coupling the memory cell to the first bit line, the second word line selectively coupling the memory cell to the second bit line; a first sense amplifier coupled to the first bit line and a reference voltage, the first sense amplifier configured to compare voltage of the first bit line to the reference voltage; and a second sense amplifier coupled to the second bit line and the reference voltage, the second sense amplifier configured to compare voltage of the second bit line to the reference voltage.

## Description

### BACKGROUND

Random-access memory (RAM) is a well-known type of memory. Memory may be a device that can store data. RAM may be memory that can be read and written in any order. To increase performance, a single-port memory can be replaced with dual-port memory. A single-port memory may be a memory that can be accessed using a single bus (e.g., a single bus for address and data). A port of a memory may be an interface to a bus. A bus can include address signals, data signals, control signals, and the like. A dual-port memory may be a memory that has two ports and can be accessed using two different buses. Dual-port memories can provide higher bandwidth than single port memories. Dual-port memories, however, can include complex memory cell circuits having an increased number of transistors per memory cell as compared to single port memories.

Demand for higher bandwidth RAM can be achieved by multiplying memory placements and/or multiplying memory frequencies. Multiplying memory placements (e.g., increasing the number of memories) can increase area consumption, increase routing complexity, and increase power consumption. Multiplying memory frequencies can increase chip clock frequencies, which in turn can increase power consumption and can require smaller-scale memories, resulting in poor area utilization.

### SUMMARY

In some embodiments, a memory circuit can include a memory cell coupled to a first word line, a first bit line, a second word line, and a second bit line. The first word line can selectively couple the memory cell to the first bit line. The second word line can selectively couple the memory cell to the second bit line. The memory circuit can include a first sense amplifier coupled to the first bit line and a reference voltage. The first sense amplifier can be configured to compare voltage of the first bit line to the reference voltage. The memory circuit can include a second sense amplifier coupled to the second bit line and the reference voltage. The second sense amplifier can be configured to compare voltage of the second bit line to the reference voltage.

In some embodiments, a memory circuit can include an array of memory cells and a controller coupled to the array of memory cells. The array of memory cells can include a memory cell coupled to a first word line, a second word line, a first bit line, and a second bit line. The first word line can selectively couple the memory cell to the first bit line. The second word line can selectively couple the memory cell to the second bit line. The controller can include a first sense amplifier coupled to the first bit line and a reference voltage. The first sense amplifier can be configured to compare voltage of the first bit line to the reference voltage. The controller can include a second sense amplifier coupled to the second bit line and the reference voltage. The second sense amplifier can be configured to compare voltage of the second bit line to the reference voltage.

In some embodiments, a method of sensing memory cells in a memory circuit can include charging a first word line to couple a first memory cell to a first bit line based on timing of a first clock signal. The method can include sensing, by a first sense amplifier, a bit stored by the memory cell by comparing voltage of the first bit line to a reference voltage. The method can include charging a second word line to couple the memory cell to a second bit line based on timing of a second clock signal, the first and second clock signals generated in response to an external clock signal. The method can include sensing, by a second sense amplifier, the bit stored by the memory cell by comparing voltage of the second bit line to the reference voltage.

### BRIEF DESCRIPTION OF THE DRAWINGS

Fig. 1 is a block diagram depicting a memory circuit according to some embodiments.
Fig. 2 is a schematic diagram depicting a 6T memory cell that can be used for each memory cell in a memory circuit according to some embodiments.
Fig. 3 is a block diagram depicting a portion of a memory circuit according to some embodiments.
Fig. 4A is a schematic diagram showing one pair of memory cells of a column in a memory array according to some embodiments.
Fig. 4B is a schematic diagram showing one pair of memory cells of a row in a memory array according to some embodiments.
Fig. 4C is a block diagram depicting reference voltage generation for sense amplifiers according to another embodiment.
Fig. 5 is a block diagram depicting a clock circuit in a controller of a memory circuit according to some embodiments.
Fig. 6 is a flow diagram depicting a method of sensing memory cells in a memory circuit according to some embodiments.

### DETAILED DESCRIPTION

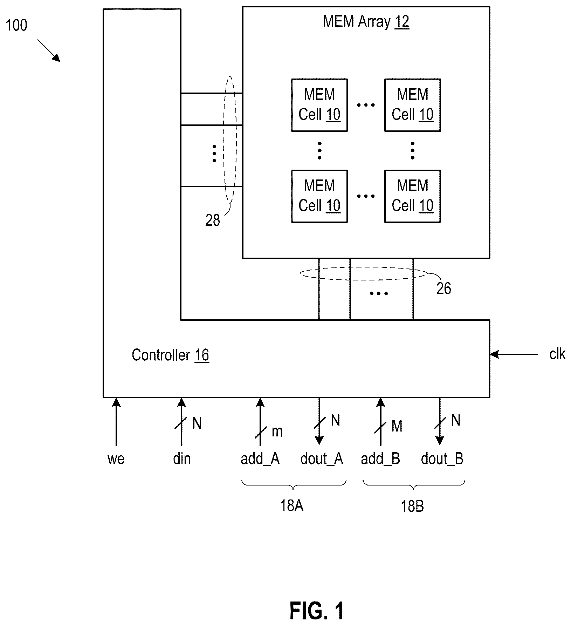

Fig. 1 is a block diagram depicting a memory circuit 100 according to some embodiments. A memory circuit may be a circuit that can store bits of data. Memory circuit 100 can include a memory array 12 (shown as MEM array 12) and a controller 16. A memory array may be a circuit that can store data in a structure of rows and columns of bits. A controller for a memory may be a circuit that supplies signals to and receives signals from a memory array. Memory array 12 can include memory cells 10 arranged in rows and columns. A memory cell may be a circuit that can store a bit of data. Controller 16 can be coupled to memory array 12 by nodes 26 and nodes 28. A node in a circuit may be a junction where two or more circuit elements are connected. Nodes 26 and 28 can include wires (e.g., conductors) to which circuit elements are connected (e.g., transistors). Each node 28 can include a wire coupled to a row of memory cells 10. Each node 26 can include a wire coupled to a column of memory cells 10. Nodes 28 can be referred to as lines, e.g., word lines. Nodes 26 can be referred to as lines, e.g., bit lines. That is, a word line may be a type of node coupled to a row of memory cells 10. A bit line may be a type of node coupled to a column of memory cells 10.

Controller 16 can include digital logic. Digital logic may be circuit(s) that manipulate digital signals. A digital signal may be a signal discrete in time and amplitude, e.g., a time-ordered sequence of binary codes. Digital logic can include logic gates, as described in some embodiments below. A logic gate may be digital logic that performs a Boolean function, e.g., AND, OR, XOR, NOT, NAND, NOR, and XNOR functions. Logic gates can be combined to create combinational logic (also referred to as combinatorial logic). Combinational logic may be digital logic where the output is a function of the present input only. Opposed to combinational logic, sequential logic may be digital logic where the output depends at least in part on past input (e.g., sequential logic can have state). Controller 16 can include combinational logic and sequential logic. Controller 16 can also include analog circuits. An analog circuit may be a circuit that manipulates analog signals. An analog signal may be a signal continuous in time and amplitude.

Digital logic, including logic gates, can be constructed using transistors, such as field effect transistors (FETs). A FET can be a four-terminal device having gate, source, drain, and substrate terminals. Unless otherwise indicated, NMOS transistors described herein have their substrate terminals coupled to VSS (e.g., electrical ground) and PMOS transistors described herein have their substrate terminals coupled to VDD (e.g., supply voltage) and, as such, the substrate terminals are not explicitly shown. FETs can be p-channel FETs or n-channel FETs, where n and p refer to the type of doping in the semiconductor material and the type of majority charge carrier, as is known in the art. Consistent with convention, any p-channel transistors are shown schematically with a bubble on the gate and any n-channel transistors are shown without such a bubble on the gate. There are many types of FETs known in the art. One skilled in the art can select among one or more such FETs based on the description of the examples and embodiments herein. Metal-oxide semiconductor field-effect transistors (MOSFETs) are widely used and well-known FETs. P-channel MOSFETs can be referred to as PMOS transistors and N-channel MOSFETs can be referred to as NMOS transistors. A circuit that includes NMOS transistor(s) and PMOS transistor(s) can be referred to as a complementary metal-oxide semiconductor (CMOS) circuit. Accordingly, some embodiments are described below within the context of NMOS transistors, PMOS transistors, and CMOS circuits.

Controller 16 can include a read port 18A and a read port 18B. That is, memory circuit 100 can be a dual-port read memory. Read port 18A can include inputs and outputs for a first bus and read port 18B can include inputs and outputs for a second bus. Read port 18A can be referred to herein as "read port A" and read port 18B can be referred to herein as "read port B." The suffix "_A" can refer to read port A and the suffix "_B" can refer to read port B. Read port 18A can include an address input (shown as add_A) and a data output (shown as dout_A). Likewise, read port 18B can include an address input (shown as add_B) and a data output (shown as dout_B). Memory circuit 100 can be a single-port write memory. Controller can include a write enable input (shown as we) and a data input (shown as din). In a general case: each address input add_A and add_B can be an M-bit input, where M is a positive integer; the write enable input we can be a one-bit input; the data input din can be an N-bit input, where N is a positive integer; and each data output dout_A and dout_B can be an N-bit output. The inputs add_A, add_B, we, and din, and signals on such inputs can be referred to by the same designation. Likewise, the outputs dout_A and dout_B and the signals on such outputs can be referred to by the same designation. A clock input (clk) can receive a clock signal. A clock signal may be a signal that oscillates between voltages representing logic 1 and logic zero (e.g., supply voltage and electrical ground, respectively) at a frequency (e.g., ideally a constant frequency).

In a read operation, controller 16 can receive an address via the input add_A on read port 18A and an address via the input add_B on read port 18B. The write enable signal can indicate that reading is enabled. Data can be output on dout_A and dout_B. In a write operation, controller 16 can receive a valid address on one of the address inputs (e.g., add_A). The write enable signal can indicate writing is enabled. Data can be input on din.

A multi-bit signal, or a range of bits in a multi-bit signal, can be described as signal<u:v>, where u and v are integers such that u ≥ 0 and v > x. A particular bit of a W-bit signal may be referred to as signal[w], where w is an integer bit index and w ∈ {0, 1, ..., W-1}. Signal[0] may be a least significant bit (LSB) and signal[W-1] may be a most significant bit (MSB). An LSB may be a bit with the least weight in a binary value and an MSB may be the bit with the most weight in a binary value. A one-bit signal, such as we, or a particular bit of a multi-bit signal, such as add_A[0], can be referred to herein as a logic signal. A multi-bit signal may be a set of logic signals. Two logic signals can be complementary, e.g., one logic signal can be a true version and the other logic signal can be a complement version (e.g., a logical NOT of the true version). Likewise, two sets of logic signals (e.g., two multi-bit signals) can be complementary. A true version of a signal pair can be designated with 't' or 'T' or can have no designation (e.g., BT_A, we, etc.). The complement version of the signal pair can be designated with 'c', 'C', 'b', or 'B' (e.g., BB_A, web, WDC_A, etc.). A logic signal can be described as enabled or enabling (e.g., making something active) or disabled or disabling (e.g., making something inactive). A logic signal can be active-high or active-low. An active-low signal can be a logic signal where logic 0 indicates enabled and logic 1 indicates disabled. An active-high signal can be a logic signal where logic 1 indicates enabled and logic 0 indicates disabled. While some signals may be described as active-high or active-low for ease of explanation, those skilled in the art will appreciate that the opposite type of logic signal can be used with an appropriate modification of the digital logic.

In some embodiments, memory circuit 100 can be a static RAM (SRAM) that can increase read bandwidth by reading from multiple ports (e.g., ports A and B) and where memory cells 10 can comprise single-port, six transistor (6T) memory cells. Typically, eight transistor (8T) memory cells can be used with a pair of word lines, one for each of port A and port B. 8T memory cells, however, exhibit increased circuit area to account for the two extra transistors per memory cell. 6T memory cells as used herein can save circuit area with respect to use of 8T memory cells. Controller 16 can include circuits configured to read from 6T memory cells as if the 6T memory cells were dual ported, as described further below.

In the embodiment of Fig. 1, memory circuit 100 can support dual-port reads. In other embodiments discussed below, internal multi-clocking in controller 16 can be used to execute sequential reads to further multiply bandwidth. In such embodiments, controller can have more than two read ports to service more than two reads per external clock cycle.

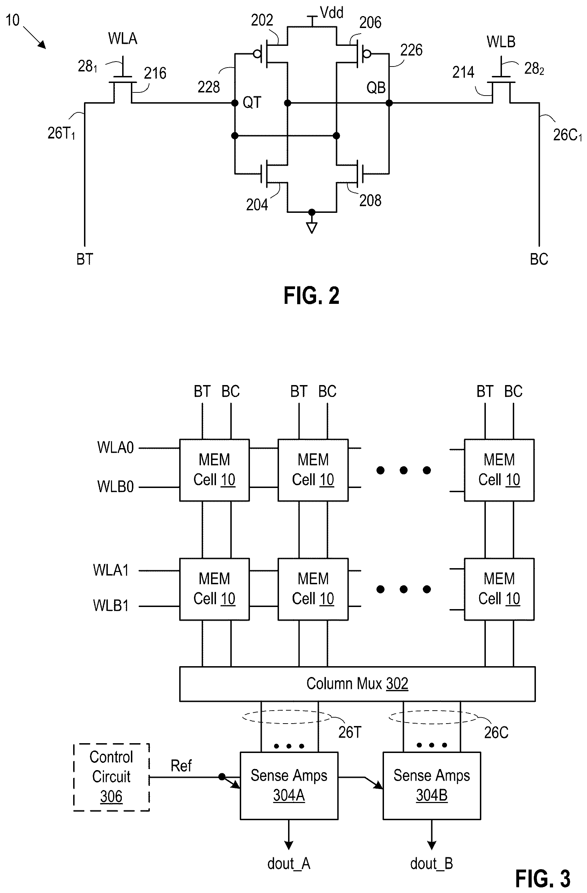

Fig. 2 is a schematic diagram depicting a 6T memory cell that can be used for each memory cell 10 in memory circuit 100 according to some embodiments. Memory cell 10 can include a cross-coupled pair of inverters, e.g., the output of one inverter can be coupled to an input of the other inverter. Cross-coupled inverters can store a bit without decay as long as the inverters remain powered. A RAM that includes such memory cells may be referred to as a static random-access memory (SRAM). A node 226 can supply a signal QT (true bit signal) and a node 228 can supply a signal QB (complement bit signal). One inverter can include PMOS transistor 202 and NMOS transistor 204. The other inverter can include PMOS transistor 206 and NMOS transistor 208.

Memory cell 10 can include NMOS transistors 214 and 216 in addition to the four inverter transistors (e.g., six total transistors for a 6T memory cell). The source and drain of transistor 214 can be coupled between a bit line 26C₁ and node 226. The source and drain of transistor 216 can be coupled between a bit line 26T₁ and node 228. The gate of transistor 216 can be coupled to a word line 28₁. The gate of transistor 214 can be coupled to a word line 28₂. Transistors 214 and 216 can operate as switches and provide a path between the bit lines and cross-coupled inverters 222, 224. A switch may be a circuit that can couple wires, e.g., a wire of one node to a wire of another node. Turning on a switch may be controlling the switch to electrically connect the wires and turning off a switch may be controlling the switch to electrically isolate the wires. Transistor 214 can be a switch that, when turned on by word line 28₂, can electrically connect bit line 26C₁ and node 226. Transistor 216 can be a switch that, when turned on by word line 28₁, can electrically connect bit line 26T₁ and node 228. When turned off by the respective word lines 28₂ and 28₁, transistors 214 and 216 can electrically isolate respective bit lines 26C₁ and 26T₁ from nodes 226 and 228. Those skilled in the art will appreciate that other types of switches can be used that perform the function of transistors 214 and 216. Bit line 26C₁ can be referred to as BT (true bit line) and bit line 26C₁ can be referred to as BC (complement bit line). Word line 28₁ can be referred to as WLA (word line A) and word line 28₂ can be referred to as WLB (word line B). In a conventional 6T memory cell, the switch transistors (e.g., transistors 214, 216) have their gates connected to the same word line.

Fig. 3 is a block diagram depicting a portion of memory circuit 100 according to some embodiments. The portion includes memory cells 10 addressed by read port A and read port B. Controller 16 can decode the read port A and B addresses and drive a pair of word lines (WLA and WLB) with a voltage (e.g., logic high voltage). In the example of Fig. 3, world lines WLAO, WLA1, WLBO, and WLB1 are shown. In this example, the port A address can select one of WLAO or WLA1 and the port B address can select one of WLBO or WLB1. The portion shows multiple columns of memory cells 10. Each column includes bit lines BT and BC coupled to the respective memory cells (as shown in Fig. 2). Each memory cell 10 can be a 6T memory cell (e.g., as shown in Fig. 2). A port A word line (e.g., WLAO, WLA1) can be coupled to the gate of transistor 216 in each memory cell 10. A port B word line (e.g., WLBO, WLB1) can be coupled to the gate of transistor 214 in each memory cell 10. While only two rows of memory cells are shown, memory circuit 100 can include more than two rows of memory cells.

The true and complement bit lines can be coupled to a column multiplexer (mux) 302 of controller 16. Column multiplexer 302 can couple the true bit lines to sense amplifiers 304A (e.g., sense amplifiers for port A). Column multiplexer 302 can couple the complement bit lines to sense amplifiers 304B (e.g., sense amplifiers for port B). Other bit lines (true and complement) can be coupled to column multiplexer 302 for other memory cells 10 (not shown). Controller 16 can control column multiplexer 302 to couple the bit lines for the addressed memory cells to the sense amplifiers. A sense amplifier may be a circuit, such as an analog circuit, which amplifies and detects voltage of a signal, e.g., a voltage difference. Each sense amplifier 304A can detect a voltage difference between a respective true bit line and a reference voltage. Each sense amplifier 304B can detect a voltage difference between a respective complement bit line and the reference voltage. In some embodiments, a control circuit 306 can supply the reference voltage to each sense amplifier 304A and each sense amplifier 304B. The control circuit 306 can be a circuit that supplies a fixed voltage (e.g., Vdd). In other embodiments, control circuit 306 can be omitted and the sense amplifiers can receive their reference voltage from another source. A control circuit may be a circuit that can control another circuit. For example, each sense amplifier can receive its reference voltage from other bit lines (as described further below). Further, each sense amplifier 304A and 304B can be configured with an offset voltage. The outputs of sense amplifiers 304A can provide the data output for port A (dout_A). The outputs of sense amplifiers 304B can provide the data output for port B (dout_B).

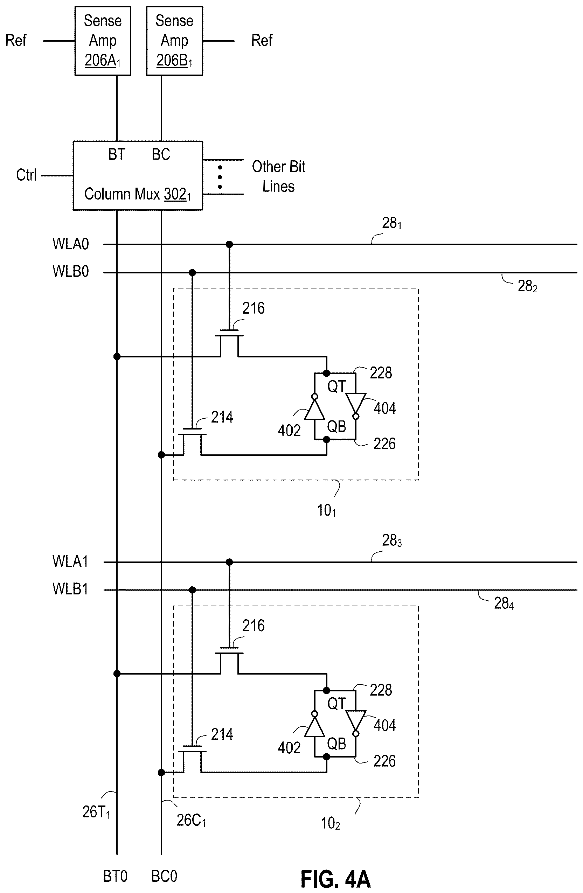

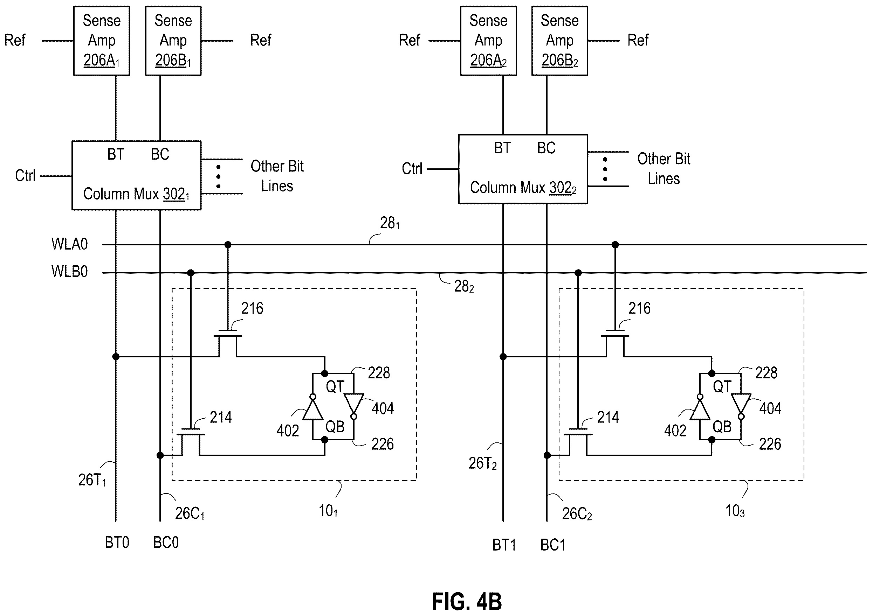

Fig. 4A is a schematic diagram showing one pair of memory cells of a column in memory array 12 according to some embodiments. Fig. 4B is a schematic diagram showing one pair of memory cells of a row in memory array 12 according to some embodiments. As shown in Fig. 4A, a memory cell 10₁ can be a 6T memory cell as shown in Fig. 2. Transistors 202, 204, 206, and 208 are represented by cross-coupled inverters 402 and 404. Likewise, a memory cell 10₂ can be a 6T memory cell as shown in Fig. 2. Gates of transistors 214 and 216 in memory cell 10₁ can be coupled to the word lines WLBO and WLAO, respectively. Gates of transistors 214 and 216 in memory cell 10₂ can be coupled to the word lines WLB1 and WLA1, respectively. The pass gates of memory cells 10₁ and 10₂ (e.g., transistors 214 and 216) can couple the memory cells to the bit lines BC0 and BTO, respectively. A column multiplexer 302₁ can couple the true bit line (BT0) to a sense amplifier 206A₁ and the complement bit line (BC0) to a sense amplifier 206B₁. In the embodiment, each sense amplifier 206A₁ and 206B₁ can receive a reference voltage from a source (embodiments of the source described further below). Each sense amplifier 206A₁ and 206B₁ can be configured with an offset voltage. An offset voltage of an amplifier with differential input may be the voltage difference that must be applied between the input terminals to change the output voltage. Column multiplexer 302₁ can be coupled to other bit lines in the memory array and can receive a control input configured to cause column multiplexer 302₁ to select a specific true bit line and a specific complement bit line to be coupled to sense amplifiers 206A₁ and 206B₁. Word lines 28₁ and 28₂ can be WLAO and WLBO and word lines 28₃ and 28₄ can be WLA1 and WLB1. Bit lines 28T₁ and 28C₁ can be BT0 and BC0.

As shown in Fig. 4B, memory cell 10₁ can be in a row with another memory cell 10₃ (memory cell 10₂ is omitted from Fig. 4B). Memory cell 10₃ can be a 6T memory cell as shown in Fig. 2. Transistors 202, 204, 206, and 208 are represented by cross-coupled inverters 402 and 404. Gates of transistors 214 and 216 in memory cell 10₃ can be coupled to the word lines WLBO and WLAO, respectively. The pass gates of memory cell 10₃ (e.g., transistors 214 and 216) can couple the memory cell to the bit lines BC1 and BT1, respectively. A column multiplexer 302₂ can couple the true bit line (BT1) to a sense amplifier 206A₂ and the complement bit line (BC1) to a sense amplifier 206B₂. In the embodiment, each sense amplifier 206A₂ and 206B₂ can receive a reference voltage from a source (embodiments of the source described further below). Each sense amplifier 206A₂ and 206B₂ can be configured with an offset voltage. Column multiplexer 302₂ can be coupled to other bit lines in the memory array and can receive a control input configured to cause column multiplexer 302₂ to select a specific true bit line and a specific complement bit line to be coupled to sense amplifiers 206A₂ and 206B₂. Bit lines 28T₂ and 28C₂ can be BT1 and BC1.

In a conventional configuration of a 6T memory cell, when reading, a single word line is charged, causing the true bit line to be charged/discharged based on QT, and the complement bit line to be charged/discharged based on QB. A node can be charged by applying a charging voltage to the node. A node may be discharged by removing the charging voltage from the node or applying a discharging voltage to the node. The bit lines BT and BC will always be opposite in voltage (true and complement). A sense amplifier can sense this voltage difference and determine the logic value stored by the memory cell.

In the embodiment, each 6T memory cell can be controlled by two word lines (a port A word line and a port B word line). When reading, the sense amplifiers do not sense the voltage difference between BT and BC. Rather, one sense amplifier for port A can sense the voltage difference between BT and the reference voltage and another sense amplifier for port B can sense the voltage difference between BC and the reference voltage. When reading from port A, controller 16 can charge a word line (e.g., WLAO or WLA1), which causes bit line BT0 to charge/discharge based on QT of a selected memory cell (e.g., memory cell 10₁ or memory cell 10₂). Sense amplifier 206A₁ can compare the voltage on bit line BT0 to its reference voltage to detect the value of QT and hence the bit stored by the selected memory cell. When reading from port B, controller 16 can charge another word line (e.g., WLBO or WLB1), which causes bit line BC0 to charge/discharge based on QB of a selected memory cell (e.g., memory cell 10₁ or memory cell 10₂). Sense amplifier 206B₁ can compare the voltage on bit line BC0 to its reference voltage to detect the value of QB and hence the bit stored by the selected memory cell.

Each sense amplifier can include an offset voltage for sensing a logic one. A logic state may be a stage of logic one or logic zero. In some embodiments, the offset voltage can be programmable. In embodiments, the reference voltage can be at or near a logic high voltage (e.g., Vdd). When sensing a logic one stored by a memory cell, there can be little or no differential generated at the sense amplifier inputs between the bit line and the reference voltage. This differential can be insufficient to overcome the offset voltage and the sense amplifier can output a logic state of logic one. For reading a logic zero, the bit line to reference voltage differential can overcome the offset voltage of the sense amplifier. In case of reading a logic zero, the input voltage difference can be sufficient to overcome the offset voltage and change the sense amplifier output to be a logic state of logic zero.

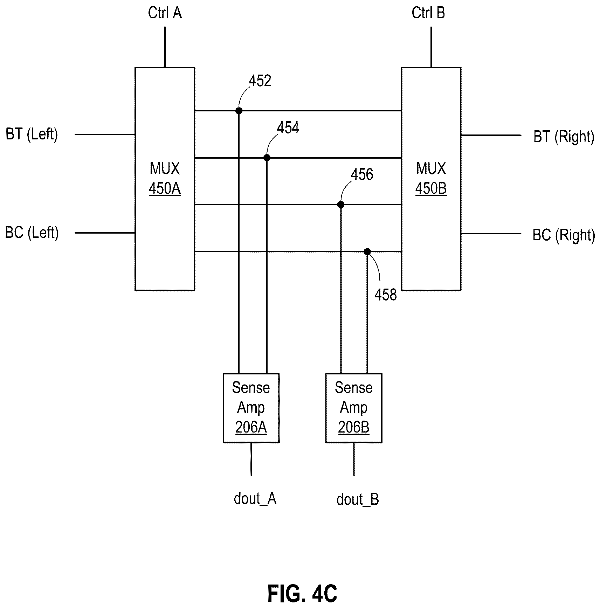

In some embodiments above, the sense amplifiers can receive a reference voltage from a control circuit (e.g., a circuit that supplies the reference voltage as a fixed voltage). Fig. 4C is a block diagram depicting reference voltage generation for sense amplifiers according to another embodiment. Memory array 12 can be logically divided into portions, e.g., two portions. One portion can be designated as left and another portion designated as right. Each sense amplifier can include a multiplexer at its input. For example, the input of sense amplifier 206A (for port A) can be coupled to an output of multiplexer 450A and the input of sense amplifier 206B (for port B) can be coupled to an output multiplexer 450B. The input of multiplexer 450A can be coupled to true and complement bit lines from the left portion of memory array 12 (shown in Fig. 1). The input of multiplexer 450B can be coupled to true and complement bit lines from the right portion of memory array 12 (shown in Fig. 1). The inputs of multiplexers 450A and 450B can be the outputs of column multiplexers that select columns from the left and right arrays, respectively. The output of multiplexer 450A can be coupled to nodes 452, 454, 456, and 458. Likewise, the output of multiplexer 450B can be coupled to nodes 452, 454, 456, and 458. Multiplexer 450A can receive a control input ctrl A and multiplexer 450B can receive a control input ctrl B. Multiplexer 450A, based on ctrl A, can couple BT (left) to one of nodes 452-458 and BC (left) to another one of nodes 452-458. Likewise, multiplexer 450B, based on ctrl B, can couple BT (right) to one of nodes 452-458 and BC (right) to another one of nodes 452-458. The inputs ctrl A and ctrl B can be such that each of BT (left), BC (left), BT (right), and BC (right) can be coupled to a respective one of nodes 452, 454, 456, and 458.

The address on port A can select memory cells in either the left or right arrays. Likewise, the address on port B can select memory cells in either the left or right arrays. Assume, for example, the addresses on ports A and B select memory cells in the left array. Multiplexer 450A can couple BT (left) to node 452 and BC (left) to node 456. Multiplexer 450B can couple BT (right) to node 454 and BC (right) to node 458. BT (right) and BC (right) originate from the right array, which is not addressed by ports A and B in the example. BT (right) and BC (right) can in this case supply references for sense amplifiers 206A and 206B. Obtaining references from unaddressed bit lines can be advantageous over supplying a fixed reference voltage from a supply circuit. For example, the unaddressed bit lines can be configured the same or similar as the addressed bit lines, which includes being subject to the same or similar noise, the same or similar process, temperature, and voltage (PVT) variations, and the like. Thus, the reference voltages used by the sense amplifiers can be adaptive and track the noise, PVT variations, and the like of the addressed bit lines. In other examples, both port A and port B can address the right side instead of the left side. In other examples, port A can address the left side and port B can address the right side. In general, multiplexer 450A and multiplexer 450B can couple one addressed bit line and one unaddressed bit line to sense amplifier 206A. Likewise, multiplexer 450A and multiplexer 450B can couple one addressed bit line and one unaddressed bit line to sense amplifier 206B. An addressed bit line may be a bit line that is coupled to a memory cell by a switch that has been turned on by a word line. An unaddressed bit line may be a bit line that is coupled to a memory cell by a switch that has been turned off by a word line.

Other embodiments for generating a reference voltage can be employed. In another embodiment, charge sharing can be used to create a reference voltage for the sense amplifiers. In another embodiment, a coupling capacitor can be used to create the reference voltage. In another embodiment, a transistor threshold (Vt) drop can be used to create the reference voltage. In another embodiment, the reference voltage can be programmable in each of the sense amplifiers. In another embodiment, the reference voltage can be derived from a capacitance difference on internal nodes of the sense amplifiers.

In another embodiment, instead of fully multiplexing BT (left), BT (right), BC (left), and BC (right), BT (left and right) can be coupled to the inputs of sense amplifier 206A and BC (left and right) can be coupled to the inputs of sense amplifier 206B. Further, in some embodiments, the output of sense amplifier 206B can be logically inverted, since sense amplifier 206B reads the logical complement of what is stored in the memory cell.

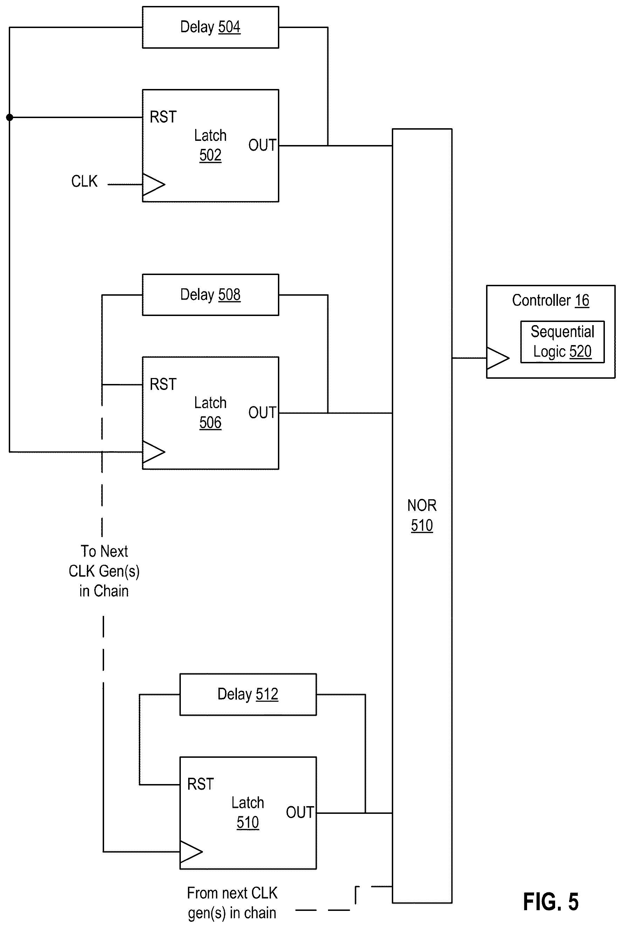

Fig. 5 is a block diagram depicting a clock circuit in controller 16 of memory circuit 100 according to some embodiments. In some embodiments, controller 16 can operate using the external clock (clk). That is, the sequential logic of controller 16 can operate using a clock having the same frequency and phase as the external clock. Bandwidth can be increased by reading from multiple ports (e.g., ports A and B) concurrently. Circuit area can be conserved by using 6T memory cells and sense amplifiers as configured in the embodiments above (e.g., two word lines per 6T memory cell). In other embodiments, controller 16 can use multi-clocking when executing sequential reads to further multiply the bandwidth of memory circuit 100. Controller 16 can include a latch 502, a delay circuit 504, a latch 506, a delay circuit 508, and a NOR gate 510. A clock input of latch 502 can be coupled to receive the external clock (clk). An output of latch 502 can be coupled to an input of NOR gate 510. The output of latch 502 can be coupled to an input of delay circuit 504. An output of delay circuit 504 can be coupled to a reset input of latch 502 and to a clock input of latch 506. An output of latch 506 can be coupled to another input of NOR gate 510. The output of latch 506 can be coupled to an input of delay circuit 508. An output of delay circuit 508 can be coupled to a reset input of latch 506. In the example, controller 16 can include two latches 502 and 506 for generating two different clock signals from the external clock signal. In other examples, controller 16 can include more than two latches and corresponding delay circuits to generate more than two different clock signals from the external clock signal (e.g., three clock signals using latch 510 and delay 512). The output of NOR gate 510 can provide an internal clock to sequential logic 520 of controller 16. The internal clock can have an increased frequency with respect to the external clock based on the generated clock signals at the input of NOR gate 510. The internal clock signal can have a frequency that is an integer multiple of the frequency of the external clock signal (e.g., twice the frequency, three times the frequency, etc.). In some embodiments, the internal clock signal can have a frequency that is a fraction multiple of the frequency of the external clock signal (e.g., three cycles for every two cycles of the external clock). In other embodiments, the internal clock frequency can be independent of the external clock frequency. Sequential logic 520 can generate control signals for memory array 12 based on the port A and B input signals (e.g., address, data, enable, etc.). The control signals can select the addressed memory cells (e.g., memory cells 10A and 10B).

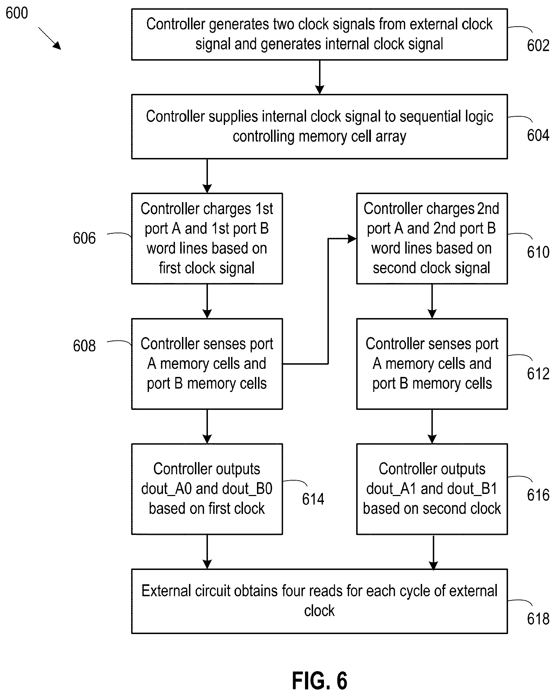

Fig. 6 is a flow diagram depicting a method 600 of sensing memory cells in a memory circuit according to some embodiments. In the embodiment, controller 16 can generate two clock signals from the external clock signal. Method 600 can begin at step 602, where controller 16 can generate the two clock signals (e.g., as shown in Fig. 5). At step 604, controller 16 can supply the internal clock signal generated from the two clock signals to sequential logic 520 that controls memory array 12. At step 606, controller 16 can charge a first port A and first port B word lines based on timing of the first clock signal. At step 608, controller 16 can sense port A and port B memory cells as selected by the first port A and first port B word lines (per the timing of the first clock). At step 610, controller 16 can charge second port A and second port B word lines based on timing of the second clock signal. At step 612, controller 16 can sense port A and port B memory cells as selected by the second port A and second port B word lines (per the timing of the second clock). At step 614, controller 16 can output a dout_A0 and a dout_B0 based on the timing of the first clock. At step 616, controller 16 can output a dout_A1 and a dout_B1 based on the timing of the second clock. At step 618, an external circuit can obtain four reads for each cycle of the external clock (e.g., dout_A0, dout_B0, dout_A1, and dout_B1).

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" and its derivatives include: (a) electrical, magnetic, and communicative coupling; and (b) do not imply a direct connection, but rather may include intervening elements, unless described as "directly coupled."

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A memory circuit, comprising:
a memory cell coupled to a first word line, a second word line, a first bit line, and a second bit line, the first word line selectively coupling the memory cell to the first bit line, the second word line selectively coupling the memory cell to the second bit line;
a first sense amplifier coupled to the first bit line and a reference voltage, the first sense amplifier configured to compare voltage of the first bit line to the reference voltage; and
a second sense amplifier coupled to the second bit line and the reference voltage, the second sense amplifier configured to compare voltage of the second bit line to the reference voltage.

2. The memory circuit of claim 1, wherein
the first sense amplifier is configured with an offset voltage and to output a first logic state when a difference between the voltage of the first bit line and the reference voltage exceeds the offset voltage and a second logic state otherwise.

3. The memory circuit of claim 1 or 2, further comprising:
a first multiplexer configured to couple the first sense amplifier to the first bit line and the second sense amplifier to the second bit line.

4. The memory circuit of claim 3, further comprising:
a second multiplexer configured to couple the first sense amplifier to a third bit line and the second sense amplifier to a fourth bit line; and
wherein the third and the fourth bit lines are configured to supply the reference voltage.

5. The memory circuit of any one of the claims 1 to 4, further comprising:
a control circuit configured to supply the reference voltage to the first sense amplifier and the second sense amplifier.

6. The memory circuit of any one of the claims 1 to 5, wherein
each of the first memory cell and the second memory cell is a six-transistor, 6T, memory cell.

7. The memory circuit of claim 6, wherein
the 6T memory cell includes cross-coupled inverters, a first switch coupling the cross-coupled inverters to the first bit line, and a second switch coupling the cross-coupled inverters to the second bit line, and wherein the first word line is configured to control the first switch and the second word line is configured to control the second switch.

8. The memory circuit of any one of the claims 1 to 7, further comprising:
a clock circuit configured to generate a first clock signal and a second clock signal from an external clock signal; and
sequential logic configured to charge the first word line or the second word line in a first read operation based on timing of the first clock signal, and charge the first word line or the second word line in a second read operation based on timing of the second clock signal.

9. A memory circuit arrangement, comprising:
an array of memory cells; and
a controller coupled to the array of memory cells;
the array of memory cells including:
a memory cell as set forth in any one of the preceding claims.

10. A method of sensing memory cells in a memory circuit, comprising:
charging a first word line to couple a memory cell to a first bit line based on timing of a first clock signal;
sensing, by a first sense amplifier, a bit stored by the memory cell by comparing voltage of the first bit line to a reference voltage;
charging a second word line to couple the memory cell to a second bit line based on timing of a second clock signal, the first and second clock signals generated in response to an external clock signal; and
sensing, by a second sense amplifier, the bit stored by the memory cell by comparing voltage of the second bit line to the reference voltage.

11. The method of claim 10, further comprising:
configuring, at the first sense amplifier, an offset voltage;
outputting, by the first sense amplifier, a first logic state when a difference between the voltage of the first bit line and the reference voltage exceeds the offset voltage and a second logic state otherwise.

12. The method of claim 10 or 11, further comprising:
coupling, by a first multiplexer, the first bit line to the first sense amplifier and the second bit line to the second sense amplifier.

13. The method of claim 12, further comprising:
coupling, by a second multiplexer, a third bit line to the first sense amplifier and a fourth bit line to the second sense amplifier, the third and fourth bit lines providing the first and second reference voltages, respectively.

14. The method of any one of the claims 10 to 13, wherein
each of the first memory cell and the second memory cell is a six-transistor (6T) memory cell.

15. The method of claim 14, wherein
the 6T memory cell includes cross-coupled inverters, a first switch coupling the cross-coupled inverters to the first bit line, and a second switch coupling the cross-coupled inverters to the second bit line, and wherein the first word line is configured to control the first switch and the second word line is configured to control the second switch.
